# EUROPEAN PATENT SPECIFICATION

(11) **EP 2 978 285 B1**
(45) Date of publication and mention of the grant of the patent: **02.10.2019**
(21) Application number: 15174441.4
(22) Date of filing: 30.06.2015
(51) Int. Cl.: H05K 1/02, B41M 7/00, B29C 53/84, B29C 53/00, H01L 23/498, H01L 23/538, H01L 23/15, H01L 21/48, B29C 61/00, B29C 61/02, H05K 1/16, H05K 1/09, H05K 1/03, B29K 25/00

(54) **IMPROVED METHOD FOR FABRICATING PRINTED ELECTRONICS**
VERBESSERTES VERFAHREN ZUR HERSTELLUNG GEDRUCKTER ELEKTRONIK
PROCÉDÉ AMÉLIORÉ POUR FABRIQUER DES CIRCUITS ÉLECTRONIQUES IMPRIMÉS

(30) Priority: 07.07.2014 US 201462021574 P
(43) Date of publication of application: 27.01.2016
(73) Proprietor: Hamilton Sundstrand Corporation, Charlotte, NC 28217 (US)
(72) Inventor: DARDONA, Sameh, South Windsor, Connecticut 06074 (US); SCHMIDT, Wayde R., Pomfret Center, Connecticut 06259 (US); CULP, Slade R., Coventry, Connecticut 06238 (US)
(74) Representative: Dehns

(56) References cited:
- EP-A1- 1 514 680
- WO-A1-2006/066040
- WO-A1-2009/102077
- WO-A1-2010/081873
- US-A1- 2008 157 235
- US-A1- 2013 213 817
- US-B1- 8 114 485

## Description

### BACKGROUND OF THE INVENTION

### 1. Field of the Invention

The present disclosure relates to electrical and optical components, and more particularly to printed electrical and optical components.

### 2. Description of Related Art

Electrical and optical components, for example wire traces and circuit components such as resistors, capacitors, and transistors may be created using direct-write technology. Direct-write technology involves printing micro, meso and nano-sized circuits or circuit components without using lithographic techniques. In direct-write technology a direct-write ink including a conductive, semiconductive or insulating material may be deposited or direct-written on a substrate to form an electrical or optical component.

One challenge in fabricating components via direct write technology is printing very small traces with properties equivalent to those of their bulk materials. For instance, typical printed silver nanoparticle-based inks exhibit conductivities substantially less than that of silver bulk. This is due in part to remaining organic additives commonly found in available liquid inks and/or residual porosity and grain boundaries after post-processing as in thermal or laser-based sintering of nanoparticles. Extended sintering times, for example greater than 3 hours, at high temperatures, for example greater than 300°C can reduce porosity and increase density. However, such processes diminish the practicality for efficient industrial production processes and can also limit the choice of suitable substrates.

US 2013/0213817 A1 discloses a method for shrinking a line width on a substrate by applying a stretching force, defining a line, and releasing the applied force.

Such conventional methods and systems have generally been considered satisfactory for their intended purpose. However, there is still a need in the art for an improved method for fabricating printed electronics. The present disclosure provides a solution for this need.

### SUMMARY OF THE INVENTION

A method for fabricating printed electronics and optical components is recited in claim 1 and includes printing a trace of electrically conductive, semiconductive or insulating material on a substrate and shrinking the substrate to a target size. The step of shrinking includes stretching the substrate during printing by an applied potential or tension and releasing the potential or tension force when printing is completed.

The material can include an ink, solution, dispersion, powder, slurry, paste or the like. The step of shrinking can include heating the substrate at a predetermined temperature based on properties of the substrate. The step of shrinking can also include heating the substrate for a predetermined duration based on properties of the substrate. For example, the substrate may decrease in area by about fifty percent during heating.

In certain embodiments, the substrate is preselected based on material properties and can be polystyrene, dielectric elastomer or electroactive polymer, for example. The substrate can be biaxially stretched and/or prestrained, e.g., prior to printing.

In embodiments, an electrical or optical component is manufactured using the method described above. During the process of shrinking, the electrical or optical component may decrease in area by at least fifty percent. An example of an electrical component may be a resistor which decreases in size and in resistance value. An additional example of an electrical component is capacitor which decreases in area. An example of an electrical component may be a coil which decreases to a smaller diameter with increased conductivity. An additional example of an optical component is a photoresponsive thin film which decreases to a smaller area and increases in density. An additional example of an electrical component is an interdigitated electrode which decreases in size and decreases in resistance and would have smaller gap between the electrode fingers.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, examples will be described in detail herein below by way of example only and with reference to certain figures, wherein:
Fig. 1 is a flow chart of an example of a method in accordance with the present disclosure, showing processes for printing and shrinking printed electronics;
Fig. 2a is a plan view of a trace material printed on a substrate prior to heating in accordance with the disclosure;
Fig. 2b is a detailed view of two of the trace lines of material as shown in Fig. 2a;
Fig. 2c is a microscopic view of the trace lines of material as shown in Fig. 2b;
Fig. 3a is a plan view of the trace material of Fig 2a after heating in accordance with the disclosure;
Fig. 3b is a detailed view of two of the trace lines of material as shown in Fig. 3a; and
Fig. 3c is a microscopic view of the trace lines of material as shown in Fig. 3b.

### DETAILED DESCRIPTION OF EXAMPLES

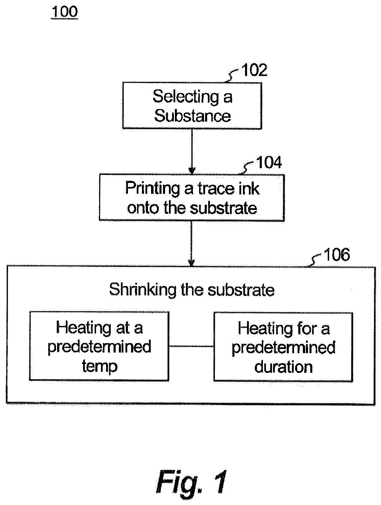

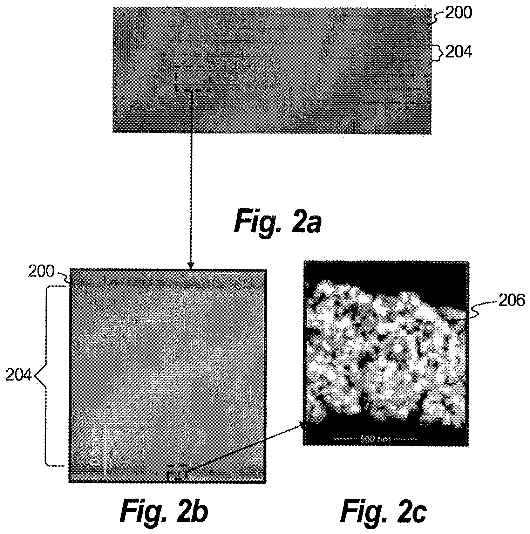

Reference will now be made to the drawings wherein like reference numerals identify similar structural features or aspects of the subject disclosure. For purposes of explanation and illustration, and not limitation, a partial view of an example of the method for fabricating printed electronics in accordance with the disclosure is shown in Fig. 1 and is designated generally by reference character 100. Other examples in accordance with the disclosure, or aspects thereof, are provided in Figs. 2a-3c, as will be described.

The present disclosure improves the properties of direct write-printed materials while simultaneously reducing the feature size of the printed structure. The process involves using a selected substrate, for example a bi-axially stretched polystyrene sheet or other organic material, to pull ink particles together, i.e., by shrinkage, during exposure of the substrate to an external energy source to form higher density traces with a decreased area.

Polystyrene and other organic materials can be manufactured in biaxially, or selectively oriented, stretched sheets. When these sheets are heated, the polystyrene chains return to their most stable configuration. The polystyrene chains are said to 'remember' their most stable configurations, even though they can be 'frozen' into a less stable configuration, i.e., biaxially stretched, by rapid cooling during manufacture. In such processes, the polystyrene shrinks dramatically during heating, but its mass stays the same. The decrease in area is compensated for by an increase in the thickness. Polystyrene is just one example of a family of 'heat shrinkable' materials that are suitable as substrates for demonstration of this invention. Other examples of suitable materials include but are not limited to thermoplastics such as polyolefins, fluoropolymers (e.g. fluorinated ethylene propylene (FEP), polytetrafluoroethylene (PTFE), Kynar, Viton and the like), neoprene, silicone, polyvinylchloride (PVC), and the like. Any other suitable materials can be used without departing from the scope of this disclosure.

With reference to Fig. 1, the method 100 includes selecting a proper substrate that is either pre-strained, stretched, or the like, as represented by box 102. The substrate may belong to the electroactive polymers family, for example, dielectric elastomers. Next, a trace of suitable material, such as an electrically conductive metal-based ink, a semiconductor-based ink or a dielectric or insulating material is printed onto the selected substrate as represented by box 104. The printed ink can include ink or a metal based powder. The printed ink is applied to the substrate in a defined geometry to produce a desired electrical component. As represented by box 106, the substrate is shrunk by heating the substrate at a predetermined temperature and duration based on the properties of the selected substrate. The temperature and duration may also be based on the target size required for the electrical or optical component.

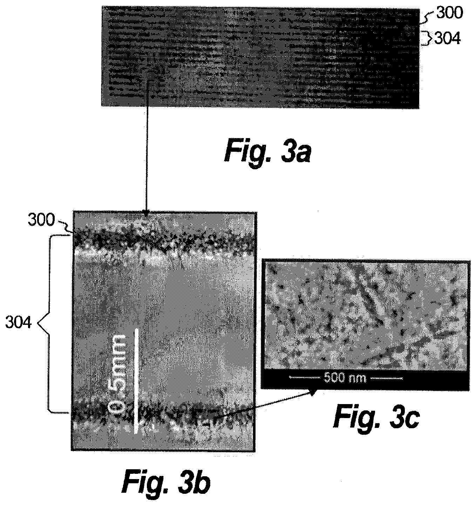

In one example of the above described method, a trace of ink, e.g., silver, is printed onto a bi-axially stretched sheet of polystyrene. With reference to Fig. 2a, printed silver lines 200 are separated by a gap 204. Fig. 2b shows the width of the printed silver lines 200 after printing and prior to heating. Prior to heating, the printed ink 200 is relatively high in porosity, relatively low in density, and has a relatively low electrical conductivity. Fig. 2c illustrates the particles of the trace lines prior to heating with gaps 206 in-between the particles. The relatively high porosity and impurities limit performance of an electrical component created through conventional direct-write technology. The polystyrene substrate is then heated at nominally 150°C for about 3 minutes. As shown in Fig. 3a, after heating, the printed silver lines 300 and gap 304 are shrunk to at least 40% of the original separation. In other words, the gap 304 between the printed lines has shrunk to at least 40% of gap 204, and the printed electrical component as a whole has therefore shrunk to at least 16% of the original area. As a result of the shrinkage, the ink particles used in printing are pulled closer together or consolidated to form a more dense trace. As shown in Fig. 3b, the printed lines 300 are closer together, narrower and thicker than lines 200. Fig. 3b shows the decreased width of the printed lines 300 and Fig. 3c illustrates how the disclosed method provides for relatively low porosity, relatively high density and relatively high conductivity. The features shape and in-plane aspect ratio of the originally printed structure are retained in the resulting miniaturized electrical or optical component. This allows for a relatively smaller electrical or optical component than achieved with conventional direct write methods and thus a higher density of devices, i.e., more devices per unit area can be fabricated. Moreover, as the substrate is heated, the printed ink may become partially embedded in the polysterene substrate, which may provide improved durability.

The electrical and optical component has been shown and described in general terms, however it will be understood by those skilled in the art, that an electrical and optical component can include, but is not limited to, electrical circuits and elements, sensors, strain gages, light sources, light sensors, heating and de-icing circuits, radio frequency identification devices (RFIDs), antennas, interdigitated electrodes for light detection, magnetic structures, or any other suitable device. For example, through the above described method, the resistance value of a resistor or an electrical coil can be reduced by more than 50%.

The disclosure has been shown and described using direct write printing but is applicable to a wide variety of methods, including, but not limited to, aerosol printing, screen printing, plasma spray, ultrasonic dispensing and micro cold spray. Those skilled in the art will readily appreciate that any other suitable deposition process can be used without departing from the scope of the disclosure.

The methods and systems of the present disclosure, as described above and shown in the drawings, provide for an improved method for fabricating printed electronics with superior properties including decreasing size while increasing density. While the apparatus and methods of the subject disclosure have been shown and described with reference to preferred embodiments, those skilled in the art will readily appreciate that changes and/or modifications may be made thereto without departing from the scope of the subject disclosure.

## Claims

1. A method for fabricating printed electronics:
printing (104) a trace of electrically conductive, semiconductive, or insulating material on a substrate; and
shrinking (106) the substrate to a target size;
**characterised in that** the step of shrinking (106) includes initially stretching the substrate during printing by an external electric potential and removing the external electric potential to shrink the substrate.

2. The method of claim 1, wherein the step of shrinking (106) includes heating the substrate at a predetermined temperature based on properties of the substrate.

3. The method of claim 1 or 2, wherein the step of shrinking (106) includes heating the substrate for a predetermined duration based on properties of the substrate.

4. The method of any preceding claim, wherein the substrate is biaxially stretched.

5. The method of any preceding claim, wherein the substrate is selected from the group consisting of polystyrene, thermoplastics, neoprene, silicone, and polyvinylchloride (PVC).

6. The method of any preceding claim, wherein the substrate is prestrained.

7. The method of any preceding claim, wherein the substrate decreases in area by at least fifty percent during heating.

8. An electrical component manufactured by the process comprising:
printing (104) an electrically conductive metal-based ink onto a substrate; and
shrinking (106) the substrate to a target size;
wherein the step of shrinking (106) includes initially stretching the substrate during printing by an external electric potential and removing the external electric potential to shrink the substrate.

9. The electrical component of claim 8, wherein during the process of shrinking (106) the electrical component decreases in area by at least fifty percent.

10. The electrical component of claim 8 or 9, wherein the electrical component is a resistor.

11. The electrical component of claim 8 or 9, wherein the electrical component is a capacitor.

12. The electrical component of claim 8 or 9, wherein the electrical component is a coil.

13. The electrical component of claim 8 or 9, wherein the electrical component is an electroactive polymer.

14. The electrical component of claim 8 or 9, wherein the electrical component is a magnetic device.

## Patentansprüche

1. Verfahren zur Herstellung gedruckter Elektronik:
Drucken (104) einer Spur aus elektrisch leitfähigem, halbleitfähigem oder isolierendem Material auf ein Substrat; und
Schrumpfen (106) des Substrats zu einer Zielgröße;
**dadurch gekennzeichnet, dass** der Schritt des Schrumpfens (106) das anfängliche Strecken des Substrats während des Druckens durch ein externes elektrisches Potential und das Entfernen des externen elektrischen Potentials, um das Substrat zu schrumpfen, beinhaltet.

2. Verfahren nach Anspruch 1, wobei der Schritt des Schrumpfens (106) das Erwärmen des Substrats bei einer vorbestimmten Temperatur basierend auf Eigenschaften des Substrats beinhaltet.

3. Verfahren nach Anspruch 1 oder 2, wobei der Schritt des Schrumpfens (106) das Erwärmen des Substrats über eine vorbestimmte Dauer basierend auf Eigenschaften des Substrats beinhaltet.

4. Verfahren nach einem vorhergehenden Anspruch, wobei das Substrat biaxial gestreckt wird.

5. Verfahren nach einem vorhergehenden Anspruch, wobei das Substrat aus der Gruppe ausgewählt ist, die aus Polystyrol, Thermoplasten, Neopren, Silikon und Polyvinylchlorid (PVC) besteht.

6. Verfahren nach einem vorhergehenden Anspruch, wobei das Substrat vorgespannt ist.

7. Verfahren nach einem vorhergehenden Anspruch, wobei die Fläche des Substrats während des Erwärmens um mindestens fünfzig Prozent abnimmt.

8. Elektrische Komponente, hergestellt durch den Prozess, der Folgendes umfasst:
Drucken (104) einer elektrisch leitfähigen metallbasierten Tinte auf ein Substrat; und
Schrumpfen (106) des Substrats zu einer Zielgröße;
wobei der Schritt des Schrumpfens (106) das anfängliche Strecken des Substrats während des Druckens durch ein externes elektrisches Potential und das Entfernen des externen elektrischen Potentials, um das Substrat zu schrumpfen, beinhaltet.

9. Elektrische Komponente nach Anspruch 8, wobei die Fläche der elektrischen Komponente während des Prozesses des Schrumpfens (106) um mindestens fünfzig Prozent abnimmt.

10. Elektrische Komponente nach Anspruch 8 oder 9, wobei die elektrische Komponente ein Resistor ist.

11. Elektrische Komponente nach Anspruch 8 oder 9, wobei die elektrische Komponente ein Kondensator ist.

12. Elektrische Komponente nach Anspruch 8 oder 9, wobei die elektrische Komponente eine Spule ist.

13. Elektrische Komponente nach Anspruch 8 oder 9, wobei die elektrische Komponente ein elektroaktives Polymer ist.

14. Elektrische Komponente nach Anspruch 8 oder 9, wobei die elektrische Komponente eine magnetische Vorrichtung ist.

## Revendications

1. Procédé pour fabriquer des circuits électroniques imprimés :
impression (104) d'une trace de matériau électroconducteur, semi-conducteur ou isolant sur un substrat ; et
rétrécissement (106) du substrat à une taille cible ;
**caractérisé en ce que** l'étape de rétrécissement (106) comporte l'étirage initial du substrat pendant l'impression par un potentiel électrique externe et l'élimination du potentiel électrique externe pour rétrécir le substrat.

2. Procédé selon la revendication 1, dans lequel l'étape de rétrécissement (106) comporte le chauffage du substrat à une température prédéterminée sur la base des propriétés du substrat.

3. Procédé selon la revendication 1 ou 2, dans lequel l'étape de rétrécissement (106) comporte le chauffage du substrat pendant une durée prédéterminée sur la base des propriétés du substrat.

4. Procédé selon une quelconque revendication précédente, dans lequel le substrat est étiré de manière biaxiale.

5. Procédé selon une quelconque revendication précédente, dans lequel le substrat est choisi dans le groupe constitué de polystyrène, de thermoplastiques, de néoprène, de silicone et de chlorure de polyvinyle (PVC).

6. Procédé selon une quelconque revendication précédente, dans lequel le substrat est précontraint.

7. Procédé selon une quelconque revendication précédente, dans lequel la surface du substrat diminue d'au moins cinquante pour cent au cours du chauffage.

8. Composant électrique fabriqué par le procédé comprenant :
l'impression (104) d'une encre à base de métal électroconductrice sur un substrat ; et
le rétrécissement (106) du substrat à une taille cible ;
dans lequel l'étape de rétrécissement (106) comporte l'étirage initial du substrat pendant l'impression par un potentiel électrique externe et l'élimination du potentiel électrique externe pour rétrécir le substrat.

9. Composant électrique selon la revendication 8, dans lequel, au cours du processus de rétrécissement (106), la surface du composant électrique diminue d'au moins cinquante pour cent.

10. Composant électrique selon la revendication 8 ou 9, dans lequel le composant électrique est une résistance.

11. Composant électrique selon la revendication 8 ou 9, dans lequel le composant électrique est un condensateur.

12. Composant électrique selon la revendication 8 ou 9, dans lequel le composant électrique est une bobine.

13. Composant électrique selon la revendication 8 ou 9, dans lequel le composant électrique est un polymère électroactif.

14. Composant électrique selon la revendication 8 ou 9, dans lequel le composant électrique est un dispositif magnétique.
